# EUROPÄISCHE PATENTSCHRIFT

(11) **EP 3 172 078 B1**
(45) Veröffentlichungstag und Bekanntmachung des Hinweises auf die Patenterteilung: **31.10.2018**
(21) Anmeldenummer: 15766116.6
(22) Anmeldetag: 15.09.2015
(51) Int. Cl.: B60L 9/00, G01R 27/18, G01R 31/00, B60L 3/00, B60L 3/04, B60L 3/12, G01R 31/02

(54) **STROMÜBERTRAGUNGSSYSTEM UND VERFAHREN ZUM BETREIBEN EINES STROMÜBERTRAGUNGSSYSTEMS**
POWER TRANSMISSION SYSTEM AND METHOD FOR OPERATING A POWER TRANSMISSION SYSTEM
SYSTÈME DE TRANSFERT DE COURANT ET PROCÉDÉ POUR FAIRE FONCTIONNER UN TEL SYSTÈME

(30) Priorität: 18.09.2014 DE 102014218764
(43) Veröffentlichungstag der Anmeldung: 31.05.2017
(73) Patentinhaber: Siemens Mobility GmbH, 81739 München (DE)
(72) Erfinder: DI BONAVENTURA, Stefan, 91186 Büchenbach (DE); HERZOG, Markus, 90768 Fürth (DE); BRANDMEIER, Marco, 91096 Möhrendorf (DE)
(86) Internationale Anmeldenummer: PCT/EP2015/071054
(87) Internationale Veröffentlichungsnummer: WO 2016/041939

(56) Entgegenhaltungen:
- US-A1- 2013 300 430

## Beschreibung

Die Erfindung betrifft ein Stromübertragungssystem. Es gibt zahlreiche technische Gebiete, bei welchen es sicherheitskritisch ist, wenn ein Stromübertragungssystem einer Anlage einen Isolationsfehler aufweist, da der Isolationsfehler z.B. zu einem Ausfall einer Stromversorgung führen kann.

In diesen technischen Gebieten ist es bekannt, eine Isolationsfehler-Erkennungseinheit zu verwenden, um festzustellen, ob ein Stromübertragungssystem einer Anlage einen Isolationsfehler aufweist. Mithilfe einer solchen Isolationsfehler-Erkennungseinheit lässt sich ein vorhandener Isolationsfehler selbst während eines laufenden Betriebs der Anlage feststellen, jedoch ermöglicht es die Isolationsfehler-Erkennungseinheit nicht, den Isolationsfehler zu lokalisieren. Eine Lokalisierung eines Isolationsfehlers ist jedoch notwendig, um den Isolationsfehler zügig beseitigen zu können.

Dokument US 2013/0300430 A1 offenbart eine Schaltung zur Überwachung einer Isolation zwischen einem elektrischen Hochspannungssystem, insbesondere einer Antriebsbatterie, und einem Fahrgestellrahmen eines elektrisch angetriebenen Fahrzeugs. Eine Isolationsüberwachungseinrichtung überwacht dabei mittels eines Mikroprozessors eine Isolationsspannung des Hochspannungsteils und ist insbesondere in der Lage, eine fehlerhafte Isolationsspannung sowie einen Fehlerort zu bestimmen.

Eine Aufgabe der Erfindung ist, ein Stromübertragungssystem anzugeben, bei welchem eine Lokalisierung eines Isolationsfehlers aufwandsgünstig realisiert werden kann.

Diese Aufgabe wird erfindungsgemäß gelöst durch ein Stromübertragungssystem, welches zumindest ein Stromübertragungsnetz, eine Isolationsfehler-Erkennungseinheit sowie eine Isolationsfehler-Lokalisierungseinheit aufweist. Das System ist gekennzeichnet durch ein Verbindungsleitungssystem, welches mit dem Stromübertragungsnetz sowie mittels eines als Wechselschalter ausgestalteten Schalters wahlweise mit der Isolationsfehler-Erkennungseinheit oder der Isolationsfehler-Lokalisierungseinheit elektrisch verbunden ist, wobei der Schalter dazu vorbereitet ist, die elektrische Verbindung der Isolationsfehler-Erkennungseinheit mit dem Stromübertragungsnetz zu trennen und die Isolationsfehler-Lokalisierungseinheit elektrisch mit dem Stromübertragungsnetz zu verbinden.

Die Erfindung geht von der Überlegung aus, dass sich ein Isolationsfehler des Stromübertragungssystems mit einer Isolationsfehler-Lokalisierungseinheit lokalisieren lässt. Als Isolationsfehler-Lokalisierungseinheit kann eine Vorrichtung oder ein System aus Vorrichtungen aufgefasst werden, welche bzw. welches dazu eingerichtet ist, zu lokalisieren, in welchem Teil bzw. Abschnitt des Stromübertragungssystems ein gegebenenfalls vorhandener Isolationsfehler vorliegt.

Ein Problem beim Einsatz einer solchen Isolationsfehler-Lokalisierungseinheit ist, dass durch einen Prüfstrom, den die Isolationsfehler-Lokalisierungseinheit zum Zwecke der Lokalisierung erzeugt und durch das Stromübertragungsnetz leitet, unbeabsichtigt Signale und/oder Relais beeinflusst werden können.

Es gibt Anlagen, bei denen eine unbeabsichtigte Beeinflussung von Signalen und/oder Relais sicherheitskritisch sein kann, insbesondere während eines Betriebs einer solchen Anlage. Dazu zählen unter anderem Fahrzeuge.

Mithilfe des Schalters ist es möglich, die Isolationsfehler-Lokalisierungseinheit elektrisch vom Stromübertragungsnetz zu trennen und dadurch zu verhindern, dass die Isolationsfehler-Lokalisierungseinheit während eines sicherheitskritischen Anlagenzustands einen Prüfstrom durch das Stromübertragungsnetz leitet. Ferner ist es mithilfe des Schalters möglich, die Isolationsfehler-Lokalisierungseinheit z.B. nur dann mit dem Stromübertragungsnetz elektrisch zu verbinden, sodass die Isolationsfehler-Lokalisierungseinheit einen Prüfstrom durch das Stromübertragungsnetz leiten kann, wenn zuvor von einer Isolationsfehler-Erkennungseinheit ein Isolationsfehler festgestellt wurde.

Weiterhin kann bei der Erfindung die Isolationsfehler-Lokalisierungseinheit ein fest installierter bzw. stationärer Bestandteil des Stromübertragungssystems sein. Ein aufwendiges Auf- und/oder Abbauen der Isolationsfehler-Lokalisierungseinheit bzw. ihrer Bestandteile, wie es bei jedem Einsatz einer mobilen Isolationsfehler-Lokalisierungseinheit notwendig ist, kann dadurch vermieden werden.

Ferner kann die Isolationsfehler-Lokalisierungseinheit bei der Erfindung so ausgestaltet sein, dass automatisch mehrere Leitungen des Stromübertragungsnetzes auf einen Isolationsfehler hin überprüft werden. Zu diesem Zweck kann für jede dieser mehreren Leitungen des Stromübertragungsnetzes ein stationär angeordnetes Messgerät vorgesehen sein. Dadurch kann darauf verzichtet werden, sämtliche elektrische Leitungen des Stromübertragungssystems mithilfe eines mobilen Messgeräts einzeln auf einen Isolationsfehler hin zu überprüfen.

Das Stromübertragungssystem kann einen Anschluss zum Anschließen einer Stromquelle, insbesondere einer Gleichstromquelle, umfassen. Alternativ oder zusätzlich kann eine Stromquelle ein Bestandteil des Stromübertragungssystems sein.

Unter einem Stromübertragungsnetz kann vorliegend ein Leitungsnetz zum Übertragen elektrischen Stroms an zumindest einen Stromverbraucher verstanden werden.

Das Verbindungsleitungssystem kann eine oder mehrere Verbindungsleitungen umfassen. Eine solche Verbindungsleitung des Verbindungsleitungssystems kann dazu vorgesehen sein, ein Element des Stromübertragungssystems mit dem Stromübertragungsnetz und/oder einem anderen Element elektrisch zu verbinden.

Ein Isolationsfehler kann z.B. dann vorliegen, wenn ein Isolationswiderstand zwischen einem elektrischen Leiter des Stromübertragungssystems und einem anderen elektrischen Leiter des Stromübertragungssystems einen vorgegebenen Widerstandswert unterschreitet bzw. ein Isolationswiderstand eines elektrischen Leiter des Stromübertragungssystems gegenüber einem Erdpotential einen vorgegebenen Widerstandswert unterschreitet.

Beim Isolationsfehler kann es sich insbesondere um einen Erdschluss handeln. Unter einem Erdschluss kann eine elektrisch leitfähige bzw. niederohmige Verbindung zwischen einem elektrischer Leiter des Stromüberwachungssystem und einem geerdeten Element verstanden werden, welche nicht beabsichtigt ist.

Der Schalter weist sinnvollerweise eine Schaltstellung auf, in welcher die Isolationsfehler-Lokalisierungseinheit elektrisch vom Stromübertragungsnetz getrennt ist. Ferner weist der Schalter sinnvollerweise eine Schaltstellung auf, in welcher die Isolationsfehler-Lokalisierungseinheit mit dem Stromübertragungsnetz elektrisch verbunden ist.

Das Stromübertragungssystem weist erfindungsgemäß eine Isolationsfehler-Erkennungseinheit auf. Als Isolationsfehler-Erkennungsein-heit kann eine Vorrichtung oder ein System aus Vorrichtungen aufgefasst werden, welche bzw. welches dazu eingerichtet ist, zu ermitteln, ob das Stromübertragungssystem einen Isolationsfehler aufweist.

Die Isolationsfehler-Erkennungseinheit kann dazu verwendet werden, zunächst zu ermitteln, ob das Stromübertragungssystem einen Isolationsfehler aufweist. Dabei kann die Isolationsfehler-Erkennungseinheit insbesondere während eines laufenden Betriebs des Stromübertragungssystems bzw. einer Einrichtung, deren Bestandteil das Stromübertragungssystem ist, zu besagtem Zweck verwendet werden. Die Isolationsfehler-Lokalisierungseinheit kann anschließend zur Lokalisierung eines mithilfe der Isolationsfehler-Erkennungseinheit gefunden Isolationsfehlers eingesetzt werden.

Des Weiteren kann die Isolationsfehler-Erkennungseinheit mit dem Verbindungsleitungssystem elektrisch verbunden sein. Dabei ist der Schalter erfindungsgemäß dazu vorbereitet, eine elektrische Verbindung zwischen dem Stromübertragungsnetz und der Isolationsfehler-Erkennungseinheit zu trennen und wieder herzustellen.

Der Schalter weist also eine Schaltstellung auf, in welcher die Isolationsfehler-Erkennungseinheit vom Stromübertragungsnetz elektrisch getrennt ist. Ferner weist der Schalter eine Schaltstellung auf, in welcher die Isolationsfehler-Erkennungseinheit elektrisch mit dem Stromübertragungsnetz verbunden ist.

Mithilfe des Schalters kann auf einfache und/oder sichere Weise zwischen einer Betriebsart des Stromübertragungssystems zur Lokalisierung eines Isolationsfehlers und einer Betriebsart des Stromübertragungssystems zur Erkennung bzw. Feststellung eines Isolationsfehlers umgeschaltet werden. Zweckmäßigerweise ist die Betriebsart zur Erkennung bzw. Feststellung unter Sicherheitsaspekten unkritisch. Die Betriebsart zur Lokalisierung eines Isolationsfehlers hingegen kann unter Sicherheitsaspekten kritisch sein.

Ferner kann das Stromübertragungssystem einen weiteren Schalter aufweisen, der zusätzlich zum erstgenannten Schalter dazu vorbereitet ist, eine elektrische Verbindung zwischen dem Stromübertragungsnetz und der Isolationsfehler-Erkennungseinheit zu trennen und wieder herzustellen. Weiterhin kann eine Schaltstellung des weiteren Schalters an eine Schaltstellung des erstgenannten Schalters gekoppelt sein.

Bevorzugterweise umfasst das Verbindungsleitungssystem eine erste Verbindungsleitung, durch die der Schalter elektrisch mit dem Stromübertragungsnetz verbunden ist. Ferner ist es zweckmäßig, wenn das Verbindungsleitungssystem eine zweite Verbindungsleitung umfasst, durch die der Schalter elektrisch mit der Isolationsfehler-Lokalisierungseinheit verbunden ist. Weiter ist es zweckmäßig, wenn das Verbindungsleitungssystem eine dritte Verbindungsleitung umfasst, durch die der Schalter elektrisch mit der Isolationsfehler-Erkennungseinheit verbunden ist.

Erfindungsgemäß ist der Schalter ein Wechselschalter, insbesondere ein einpoliger Wechselschalter. Der Wechselschalter ist dazu vorbereitet, eine elektrische Verbindung zwischen dem Stromübertragungsnetz und der Isolationsfehler-Lokalisierungseinheit zu trennen und dabei eine elektrische Verbindung zwischen dem Stromübertragungsnetz und der Isolationsfehler-Erkennungseinheit herzustellen. Darüber hinaus ist der Wechselschalter dazu vorbereitet, eine elektrische Verbindung zwischen dem Stromübertragungsnetz und der Isolationsfehler-Lokalisierungseinheit herzustellen und dabei eine elektrische Verbindung zwischen dem Stromübertragungsnetz und der Isolationsfehler-Erkennungseinheit zu trennen.

Gemäß einer Ausgestaltung der Erfindung kann der Schalter als manuell betätigbarer Schalter, insbesondere als Drehschalter, oder als Relais ausgestaltet sein.

Eine vorteilhafte Weiterbildung der Erfindung sieht vor, dass das Stromübertragungssystem eine Sperrvorrichtung, insbesondere eine elektrisch steuerbare Sperrvorrichtung, umfasst. Zweckmäßigerweise ist die Sperrvorrichtung dazu vorbereitet, den Spalter zu sperren. Vorzugweise ist die Sperrvorrichtung dazu eingerichtet, den Spalter zu sperren und wieder zu entsperren. Als Sperren des Schalters kann ein Blockieren, insbesondere ein mechanisches Blockieren, einer Betätigung des Schalters aufgefasst werden. Als Entsperren des Schalters hingegen kann ein Freigeben einer Betätigung des Schalters aufgefasst werden. Unter dem Betätigen des Schalters wiederum kann ein Ändern seiner Schaltstellung verstanden werden.

Die Sperrvorrichtung ermöglicht es, eine unbeabsichtigte Betätigung des Schalters zu verhindern. Ferner kann mithilfe der Sperrvorrichtung erreicht werden, dass der Schalter nur dann betätigt werden kann, wenn eine vorgegebene Bedingung erfüllt ist.

Außerdem kann das Stromübertragungssystem eine Prüfvorrichtung zum Ermitteln einer Schaltstellung des Schalters aufweisen. Die Prüfvorrichtung kann unter anderem eine Photodiode zum Ermitteln der Schaltstellung des Schalters umfassen.

Bevorzugterweise umfasst das Stromübertragungsnetz mehrere Abzweigungsleitungen. Die Abzweigungsleitungen sind zweckmäßigerweise jeweils zum Übertragen elektrischen Stroms an zumindest einen Stromverbraucher vorgesehen. Zu diesem Zweck sind die Abzweigungsleitungen sinnvollerweise jeweils mit zumindest einem Stromverbraucher elektrisch verbunden.

Es ist vorteilhaft, wenn die Isolationsfehler-Lokalisierungseinheit eine Auswertevorrichtung aufweist. Diese Auswertevorrichtung kann dazu vorbereitet sein, einen Prüfstrom zu erzeugen. Außerdem kann die Auswertevorrichtung dazu vorbereitet sein, den Prüfstrom durch das Stromübertragungsnetz, insbesondere durch die einzelnen Abzweigungsleitungen zu leiten. Vorzugsweise ist die Isolationsfehler-Lokalisierungseinheit dazu eingerichtet, zu ermitteln, welche der Abzweigungsleitungen des Stromübertragungsnetzes einen Isolationsfehler aufweist - vorausgesetzt eine der Abzweigungsleitungen weist einen solchen Isolationsfehler auf.

Darüber hinaus ist es zweckmäßig, wenn die Isolationsfehler-Lokalisierungseinheit für jede der Abzweigungsleitungen jeweils ein Messgerät, insbesondere ein Strommessgerät, aufweist. Ferner ist es zweckmäßig, wenn die Isolationsfehler-Lokalisierungseinheit für jede der Abzweigungsleitungen jeweils einen Messwandler, insbesondere einen Stromwandler, aufweist. Weiter können die Messwandler jeweils mit einem der Messgeräte elektrisch verbunden sein. Sinnvollerweise sind die Messwandler dabei jeweils mit unterschiedlichen Messgeräten verbunden.

In bevorzugter Weise ist jeder der Messwandler an einer der Abzweigungsleitungen angeordnet. Dabei sind die Messwandler sinnvollerweise jeweils an unterschiedlichen Abzweigungsleitungen angeordnet.

Des Weiteren können die Messgeräte zur Übertragung von Daten an die Auswertevorrichtung eingerichtet sein. Zu diesem Zweck können mehrere, insbesondere alle, der Messgeräte über einen Datenbus mit der Auswertevorrichtung verbunden sein. Ferner kann zumindest eins der Messgeräte über eine separate Datenleitung mit der Auswertevorrichtung verbunden sein.

Das Stromübertragungssystem kann unter anderem ein Bestandteil eines Fahrzeugs, insbesondere eines Schienenfahrzeugs, sein. Bei dem Stromübertragungssystem kann es sich beispielsweise um einen Bestandteil eines Bordnetzsystems des Fahrzeugs handeln.

Vorliegend kann als Schienenfahrzeug ein einzelnes Triebfahrzeug oder ein Verbund aus mehreren Triebfahrzeugen aufgefasst werden. Ebenso kann ein Verbund aus zumindest einem Triebfahrzeug und zumindest einem antriebslosen Wagen als Schienenfahrzeug aufgefasst werden.

Des Weiteren kann das Fahrzeug ein Steuergerät umfassen. Die Isolationsfehler-Lokalisierungseinheit kann zur Datenübertragung an das Steuergerät vorbereitet sein, z.B. über eine Datenleitung und/oder per Funk. Außerdem kann die Isolationsfehler-Erkennungseinheit zur Datenübertragung an das Steuergerät vorbereitet sein.

In dem Fall, dass das Fahrzeug ein Schienenfahrzeug ist, kann das Steuergerät insbesondere ein Zugsteuergerät sein. Als Zugsteuergerät kann eine Vorrichtung aufgefasst werden, die u.a. dazu eingerichtet ist, Steuerbefehle für eine Stromabnehmersteuerung, ein Antriebs- bzw. Bremssystem, eine Bordnetzsteuerung und/oder eine Hilfsbetriebesteuerung zu erzeugen. Zudem kann das Zugsteuergerät als Diagnosesystem einsetzbar sein.

Ferner betrifft die Erfindung ein Verfahren zum Betreiben eines Stromübertragungssystems.

Um eine aufwandsgünstige Lokalisierung eines Isolationsfehlers zu ermöglichen, wird ein Verfahren zum Betreiben eines Stromübertragungssystems vorgeschlagen, bei dem ein Verbindungsleitungssystem elektrisch mit einem Stromübertragungsnetz sowie wahlweise mit einer Isolationsfehler-Erkennungseinheit oder einer Isolationsfehler-Lokalisierungseinheit verbunden ist, wobei bei Erfüllen einer vorgegebenen Bedingung die elektrische Verbindung der Isolationsfehler-Erkennungseinheit mit dem Stromübertragungsnetz mittels eines als Wechselschalter ausgestalteten Schalters getrennt wird und die Isolationsfehler-Lokalisierungseinheit mittels des Schalters elektrisch mit dem Stromübertragungsnetz verbunden wird.

Das Verfahren kann insbesondere zum Betreiben des erfindungsgemäßen Stromübertragungssystems und/oder einer seiner oben beschriebenen Weiterbildungen eingesetzt werden.

Erfindungsgemäß wird die Isolationsfehler-Lokalisierungseinheit nur dann mithilfe des Schalters elektrisch mit dem Stromübertragungsnetz verbunden, falls eine vorgegebene Bedingung erfüllt ist. Wenn die vorgegebene Bedingung nicht bzw. nicht mehr erfüllt ist, wird die Isolationsfehler-Lokalisierungseinheit vorzugsweise mithilfe des Schalters elektrisch vom dem Stromübertragungsnetz getrennt.

Die vorgegebene Bedingung kann unter anderem umfassen, dass sich eine Einrichtung, deren Bestandteil das Stromübertragungssystem ist, in einem vorgegebenen Zustand befindet bzw. dass sich das Stromübertragungssystem selbst in einem vorgegebenen Zustand befindet. Bei dem vorgegebenen Zustand kann es sich um einen Zustand handeln, in welchen es unter Sicherheitsaspekten unkritisch ist, wenn ein Prüfstrom durch das Stromübertragungsnetz geleitet wird.

Weiterhin kann die vorgegebene Bedingung umfassen, dass das Stromübertragungssystem einen Isolationsfehler, insbesondere einen von einer Isolationsfehler-Erkennungseinheit ermittelten Isolationsfehler, aufweist. Bei dem Isolationsfehler kann es sich z.B. um einen Erdschluss handeln.

Erfindungsgemäß wird die zuvor elektrisch mit dem Stromübertragungsnetz verbundene Isolationsfehler-Erkennungseinheit mithilfe des Schalters vom Stromübertragungsnetz getrennt, falls die vorgegebene Bedingung erfüllt ist. Diese Isolationsfehler-Erkennungseinheit kann mit dem Verbindungsleitungssystem elektrisch verbunden sein.

Sinnvollerweise ermittelt/überwacht die Isolationsfehler-Erkennungseinheit zum Erkennen eines Isolationsfehlers einen Isolationswiderstand des Stromübertragungsnetzes, insbesondere einen Isolationswiderstand bezüglich eines Erdpotentials.

Gemäß einer Ausgestaltung des erfindungsgemäßen Verfahrens wird eine Schaltstellung des Schalters ermittelt, insbesondere mithilfe einer Prüfvorrichtung, und die Schaltstellung optisch und/oder akustisch ausgegeben, insbesondere mittels eines Ausgabegeräts. Dadurch kann eine Person, die dazu berechtigt ist, den Schalter manuell zu betätigen bzw. mittels eines Steuergeräts elektrisch zu betätigen, auf einfache Weise über die Schaltstellung informiert werden.

Weiterhin kann mittels des Ausgabegeräts eine Fehlermeldung ausgegeben werden, falls die Isolationsfehler-Lokalisierungseinheit mithilfe des Schalters mit dem Stromübertragungsnetz elektrisch verbunden ist oder verbunden wird, obwohl die vorgegebene Bedingung nicht erfüllt bzw. nicht mehr erfüllt ist.

Gemäß einer weiteren Ausgestaltung des erfindungsgemäßen Verfahrens kann eine Sperrvorrichtung, insbesondere ein elektrisch steuerbare Sperrvorrichtung, vorgesehen sein. Die Sperrvorrichtung ist dazu vorbereitet, den Schalter zu sperren und wieder zu entsperren, wobei an die Sperrvorrichtung ein elektrisches Entsperrsignal übermittelt wird, falls die vorgegebene Bedingung erfüllt ist, und die Sperrvorrichtung daraufhin den Schalter entspderrt.

Sinnvollerweise wird an die Sperrvorrichtung ein elektrisches Sperrsignal übermittelt wird, falls die vorgegebene Bedingung nicht bzw. nicht mehr erfüllt ist. Zweckmäßigerweise sperrt die Sperrvorrichtung daraufhin den Schalter.

In einer vorteilhaften Ausführung der Erfindung ist der Schalter ein manuell betätigbarer Schalter. Vorzugsweise betätigt eine Person den Schalter manuell, falls die vorgegebene Bedingung erfüllt ist.

In einer weiteren vorteilhaften Ausführung der Erfindung ist der Schalter ein Relais. Vorzugsweise wird zum Betätigen des Schalters zumindest ein vorgegebenes elektrisches Signal an den Schalter übermittelt wird, falls die vorgegebene Bedingung erfüllt ist.

In dem Fall, dass der Schalter ein Relais ist, werden bevorzugterweise mehrere elektrische Signale an den Schalter übermittelt, um diesen zu betätigen. Dadurch kann ein höherer Schutz vor einer unbeabsichtigten Betätigung des Schalters erreicht werden. Insbesondere kann auf diese Weise vermieden werden, dass der Schalter betätigt wird, wenn irrtümlicherweise - z.B. aufgrund eines technischen Defekts - ein einzelnes solches Signal an den Schalter übermittelt wird.

Die Signale können voneinander unabhängige Signale sein, die sich z.B. auf unterschiedliche Zustände und/oder Größen der Einrichtung, deren Bestandteil das Stromübertragungssystem ist, beziehen.

Das Stromübertragungssystem kann gemäß einer weiteren Ausgestaltung der Erfindung ein Bestandteil eines Fahrzeugs, insbesondere eines Schienenfahrzeugs, sein. In diesem Fall kann die vorgegebene Bedingung von einem Fahrzustand, insbesondere einem momentanen Fahrzustand, des Fahrzeugs abhängig sein.

Der Fahrzustand kann sich unter anderem auf eine Fahrgeschwindigkeit des Fahrzeugs beziehen. Die vorgegebene Bedingung kann beispielsweise umfassen, dass die Fahrgeschwindigkeit des Fahrzeugs Null ist.

Falls das Fahrzeug ein Schienenfahrzeug ist, kann die vorgegebene Bedingung umfassen, dass das Schienenfahrzeug aufgerüstet abgestellt ist, eine Feststellbremse des Schienenfahrzeugs angezogen bzw. angelegt ist und/oder in einem Steuergerät des Schienenfahrzeugs ein Wartungsmodus aktiviert ist.

Unter "aufgerüstet abgestellt" kann verstanden werden, dass das Schienenfahrzeug abgestellt ist, das Schienenfahrzeug also stillsteht, und zudem seine elektrische Energieversorgung eingeschaltet ist. Weiterhin können im aufgerüstet abgestellten Zustand des Schienenfahrzeugs gegebenenfalls Hilfsbetriebe, wie z.B. ein Drucklufterzeugungssystem, aktiv sein. Sinnvollerweise ist im aufgerüstet abgestellten Zustand des Schienenfahrzeugs ein Stromabnehmer des Schienenfahrzeugs angehoben bzw. in elektrischem Kontakt mit einer Oberleitung.

Die bisher gegebene Beschreibung vorteilhafter Ausgestaltungen enthält zahlreiche Merkmale, die in den einzelnen Unteransprüchen teilweise zu mehreren zusammengefasst wiedergegeben sind. Diese Merkmale können jedoch zweckmäßigerweise auch einzeln betrachtet und zu sinnvollen weiteren Kombinationen zusammengefasst werden. Insbesondere sind diese Merkmale jeweils einzeln und in beliebiger geeigneter Kombination mit dem erfindungsgemäßen Stromübertragungssystem und dem erfindungsgemäßen Verfahren kombinierbar. So sind Verfahrensmerkmale, gegenständlich formuliert, auch als Eigenschaft der entsprechenden Vorrichtungseinheit zu sehen und umgekehrt.

Auch wenn in der Beschreibung bzw. in den Patentansprüchen einige Begriffe jeweils im Singular oder in Verbindung mit einem Zahlwort verwendet werden, soll der Umfang der Erfindung für diese Begriffe nicht auf den Singular oder das jeweilige Zahlwort eingeschränkt sein. Ferner sind die Wörter "ein" bzw. "eine" nicht als Zahlwörter, sondern als unbestimmte Artikel zu verstehen.

Die oben beschriebenen Eigenschaften, Merkmale und Vorteile der Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Die Ausführungsbeispiele dienen der Erläuterung der Erfindung und beschränken die Erfindung nicht auf die darin angegebenen Kombinationen von Merkmalen, auch nicht in Bezug auf funktionale Merkmale. Außerdem können dazu geeignete Merkmale eines jeden Ausführungsbeispiels auch explizit isoliert betrachtet, aus einem Ausführungsbeispiel entfernt, in ein anderes Ausführungsbeispiel zu dessen Ergänzung eingebracht und mit einem beliebigen der Ansprüche kombiniert werden.

Es zeigen:

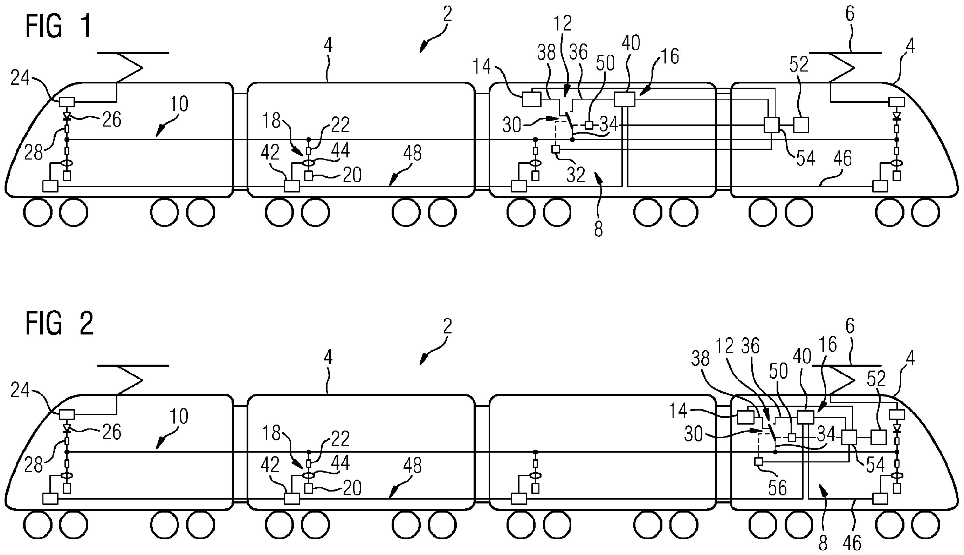

- FIG 1: ein Schienenfahrzeug mit einem Stromübertragungssystem, welches ein Stromübertragungsnetz, eine Isolationsfehler-Lokalisierungseinheit und ein Relais aufweist, welches dazu vorbereitet ist, die Isolationsfehler-Lokalisierungseinheit elektrisch vom Stromübertragungsnetz zu trennen; und
- FIG 2: ein weiteres Schienenfahrzeug mit einem Stromübertragungssystem, welches ein Stromübertragungsnetz, eine Isolationsfehler-Lokalisierungseinheit und einen manuell betätigbaren Schalter aufweist, welcher dazu vorbereitet ist, die Isolationsfehler-Lokalisierungseinheit elektrisch vom Stromübertragungsnetz zu trennen.

FIG 1 zeigt schematisch ein Fahrzeug 2. Im vorliegenden Fall handelt es sich bei dem Fahrzeug 2 um ein Schienenfahrzeug mit vier Wagen 4, die miteinander gekuppelt sind. Zwei dieser Wagen 4 sind jeweils mit einem Stromabnehmer 6 ausgestattet.

Das Fahrzeug 2 weist ein Stromübertragungssystem 8 auf, welches ein Stromübertragungsnetz 10, ein Verbindungsleitungssystem 12, eine Isolationsfehler-Erkennungseinheit 14 und eine Isolationsfehler-Lokalisierungseinheit 16 umfasst.

Des Weiteren umfasst das Stromübertragungsnetz 12 mehrere Abzweigungsleitungen 18, wobei in jedem der Wagen 4 eine der Abzweigungsleitungen 18 angeordnet ist. Die Abzweigungsleitungen 18 sind jeweils mit einem Stromverbraucher 20 des jeweiligen Wagens 4 elektrisch verbunden. Zudem weist jede der Abzweigungsleitungen 18 eine Wagenabzweigsicherung 22 auf.

Die beiden Wagen 4 mit Stromabnehmer 6 weisen jeweils eine Konvertierungseinheit 24 auf, welche mit dem jeweiligen Stromabnehmer 6 elektrisch verbunden ist und dazu eingerichtet ist, eine vom Stromabnehmer 6 bereitgestellte Wechselspannung in eine Gleichspannung umzuwandeln.

Ferner ist das Stromübertragungsnetz 10 mit den beiden Konvertierungseinheiten 24 jeweils unter Zwischenschaltung einer Entkoppeldiode 26 und einer Hauptsicherung 28 elektrisch verbunden.

Das Verbindungsleitungssystem 12 umfasst einen Schalter 30, der im vorliegend Ausführungsbeispiel als Relais, d.h. als elektrisch steuer- bzw. betätigbarer Schalter, ausgestaltet ist. Der Schalter 30 wiederum umfasst eine Betätigungseinheit 32 zum elektrischen bzw. elektromagnetischen Steuern einer Schaltstellung des Schalters 30. Außerdem ist der Schalter 30 ein Wechselschalter, der dazu vorbereitet ist, die Isolationsfehler-Erkennungseinheit 14 elektrisch von Stromübertragungsnetz 10 zu trennen und dabei die Isolationsfehler-Lokalisierungseinheit 16 mit dem Stromübertragungsnetz 10 elektrisch zu verbinden. Zudem ist der Schalter 30 dazu vorbereitet, die Isolationsfehler-Lokalisierungseinheit 16 elektrisch von Stromübertragungsnetz 10 zu trennen und dabei die Isolationsfehler-Erkennungseinheit 14 mit dem Stromübertragungsnetz 10 elektrisch zu verbinden.

Weiterhin umfasst das Verbindungsleitungssystem 12 eine erste Verbindungsleitung 34, durch die der Schalter 30 mit dem Stromübertragungsnetz 10 elektrisch verbunden ist. Zudem umfasst das Verbindungsleitungssystem 12 eine zweite Verbindungsleitung 36, durch die Isolationsfehler-Lokalisierungseinheit 16 mit dem Schalter 30 elektrisch verbunden ist, sowie eine dritte Verbindungsleitung 38, durch die Isolationsfehler-Erkennungseinheit 14 mit dem Schalter 30 elektrisch verbunden ist.

Die Isolationsfehler-Lokalisierungseinheit 16 umfasst eine Auswertevorrichtung 40, die dazu eingerichtet ist, einen Prüfstrom zu erzeugen und diesen durch das Stromübertragungsnetz 10 zu leiten. Weiter umfasst die Isolationsfehler-Lokalisierungseinheit 16 mehrere Messgeräte 42, insbesondere Strommessgeräte, und eine gleiche Anzahl von Messwandlern 44, insbesondere Stromwandlern.

In jedem der Wagen 4 ist eines der Messgeräte 42 und einer der Messwandler 44 angeordnet, wobei die jeweils im selben Wagen 4 angeordneten Messwandler 44 und Messgeräte 42 elektrisch miteinander verbunden sind. Ferner sind die Messwandler 44 jeweils an derjenigen Abzweigungsleitung 18 des Stromübertragungsnetzes 10 angeordnet, die im selben Wagen 4 wie der jeweilige Messwandler 44 angeordnet ist.

Eines der Messgeräte 42 - im vorliegenden Ausführungsbeispiel das zeichnungsgemäß am weitesten rechts angeordnete Messgerät 42 - ist über eine separate Datenleitung 46 mit der Auswertevorrichtung 40 der Isolationsfehler-Erkennungseinheit 16 verbunden. Die anderen Messgeräte 42 sind über einen gemeinsamen Datenbus 48 mit der Auswertevorrichtung 40 verbunden. Zudem ist jedes der Messgeräte 42 zur Datenübertragung an die Auswertevorrichtung 40 eingerichtet.

Das Stromübertragungssystem 8 weist außerdem eine Prüfvorrichtung 50 auf, die zum Ermitteln einer Schaltstellung des Schalters 30 eingerichtet ist. Darüber hinaus ist das Fahrzeug 2 mit einem Ausgabegerät 52 zur Ausgabe der mittels der Prüfvorrichtung 50 ermittelten Schaltstellung sowie mit einem Zugsteuergerät 54 ausgestattet.

Im vorliegenden Ausführungsbeispiel sind die Auswertevorrichtung 40 der Isolationsfehler-Lokalisierungseinheit 16, die Isolationsfehler-Erkennungseinheit 14 sowie das Verbindungsleitungssystem 12 in einem anderen Wagen 4 angeordnet als das Zugsteuergerät 54.

Die Isolationsfehler-Erkennungseinheit 14, die Isolationsfehler-Lokalisierungseinheit 16, die Prüfvorrichtung 50, die Betätigungseinheit 32 des Schalters 30 sowie das Ausgabegerät 52 sind jeweils über eine eigene Datenleitung mit dem Zugsteuergerät 54 verbunden. Prinzipiell könnte die Prüfvorrichtung 50 alternativ über eine Datenleitung direkt mit dem Ausgabegerät 52 verbunden sein.

Während einer Fahrt des Fahrzeugs 2 ist - wie FIG 1 dargestellt - die Isolationsfehler-Erkennungseinheit 14 mittels des Schalters 30 mit dem Stromübertragungsnetz 10 elektrisch verbunden und die Isolationsfehler-Lokalisierungseinheit 16 ist mittels des Schalters 30 elektrisch vom Stromübertragungsnetz 10 getrennt.

Mithilfe der Isolationsfehler-Erkennungseinheit 14 wird während der Fahrt ermittelt, ob das Stromübertragungssystem 8, insbesondere irgendeine der Abzweigungsleitungen 18 des Stromübertragungssystems 8, einen Isolationsfehler aufweist.

Im Speziellen wird mithilfe der Isolationsfehler-Erkennungseinheit 14 ermittelt, ob das Stromübertragungssystem 8 einen Erdschluss aufweist. Hierzu überwacht die Isolationsfehler-Erkennungseinheit 14 einen Isolationswiderstand des Stromübertragungsnetzes 10, insbesondere einen Isolationswiderstand bezüglich eines Erdpotentials.

Wird von der Isolationsfehler-Erkennungseinheit 14 ermittelt, dass das Stromübertragungssystem 8 einen Isolationsfehler aufweist, erzeugt die Isolationsfehler-Erkennungseinheit 14 eine entsprechende Meldung für das Zugsteuergerät 54 und übermittelt diese Meldung an das Zugsteuergerät 54. Das Zugsteuergerät 54 generiert zu der Meldung einen digitalen Zeitstempel und speichert diesen gemeinsam mit der Meldung ab. Dadurch ist bei nachfolgenden Wartungs- bzw. Diagnosearbeiten am Fahrzeug 2 feststellbar, wann der Isolationsfehler aufgetreten ist.

Zum Lokalisieren des Isolationsfehlers mithilfe der Isolationsfehler-Lokalisierungseinheit 16 wird das Fahrzeug 2 abgestellt.

Falls eine vorgegebene Bedingung erfüllt ist, wird die zuvor mittels des Schalters 30 elektrisch vom Stromübertragungsnetz 10 getrennte Isolationsfehler-Lokalisierungseinheit 16 mithilfe des Schalters 30 mit dem Stromübertragungsnetz 10 elektrisch verbunden. Dabei wird die zuvor mittels des Schalters 30 mit dem Stromübertragungsnetz 10 elektrisch verbundene Isolationsfehler-Erkennungseinheit 14 mithilfe des Schalters 30 vom Stromübertragungsnetz 10 elektrisch getrennt.

Im vorliegenden Fall umfasst die vorgegebene Bedingung, dass das Fahrzeug 2 aufgerüstet abgestellt ist, eine Feststellbremse des Fahrzeugs 2 angezogen bzw. angelegt ist und im Zugsteuergerät 54 ein Wartungsmodus aktiviert ist.

Damit der als Relais ausgestaltete Schalter 30 seine Schaltstellung in der beschrieben Weise verändert, werden vom Zugsteuergerät 54 fortdauernd drei voneinander unabhängige elektrische Signale an den Schalter 30, insbesondere an die Betätigungseinheit 32 des Schalters 30, übermittelt. Ein erstes der drei Signale umfasst eine Information darüber, dass Fahrzeug 2 aufgerüstet abgestellt. Ein zweites der drei Signale, umfasst eine Information darüber, dass eine Feststellbremse des Fahrzeugs 2 angezogen, und eine drittes der drei Signale umfasst Information darüber, dass im Zugsteuergerät 54 der Wartungsmodus aktiviert ist.

Weiterhin wird mithilfe der Prüfvorrichtung 50 fortdauernd eine Schaltstellung des Schalters 30 ermittelt und die ermittelte Schaltstellung an das Zugsteuergerät 54 übermittelt. Das Zugsteuergerät 54 wiederum übermittelt diesen an das Ausgabegerät 52, das die Schaltstellung optisch ausgibt.

Die Isolationsfehler-Lokalisierungseinheit 16 erzeugt einen Prüfstrom, der unter anderem von einer Netzspannung, die vom Stromübertragungsnetz 10 bereitgestellt wird, und von einem von der Isolationsfehler-Erkennungseinheit 14 ermittelten Isolationswiderstand des Stromübertragungsnetzes 10 abhängig ist.

Der Prüfstrom wird durch die einzelnen Abzweigungsleitungen 18 des Stromübertragungsnetzes 10 geleitet. Ferner wird von jedem der Messwandler 44 ein vom Prüfstrom abhängiges elektrisches Messsignal erzeugt, welches an das mit dem jeweiligen Messwandler 44 elektrisch verbundene Messgerät 42 übermittelt wird.

Weiterhin wird von jedem der Messgeräte 42 unter Verwendung des jeweiligen Messsignals eine vom Prüfstrom abhängige Messgröße ermittelt und zusammen mit einer eindeutigen Kennung des Messgeräts 42 an die Auswertevorrichtung 40 übermittelt.

Die Auswertevorrichtung 40 ermittelt unter Verwendung der von den Messgeräten 42 übermittelten Messgrößen, welche der Abzweigungsleitungen 18 den Isolationsfehler aufweist. Zur Identifikation derjenigen Abzweigungsleitung 18, die den Isolationsfehler aufweist, werden die eindeutigen Kennungen der Messgeräte 42 verwendet.

Des Weiteren erzeugt die Auswertevorrichtung 40 eine Meldung für das Zugsteuergerät 54, die eine Information darüber enthält, welche der Abzweigungsleitungen 18 den Isolationsfehler aufweist, und übermittelt diese Meldung an das Zugsteuergerät 54. Das Zugsteuergerät 54 wiederum leitet diese Meldung an das Ausgabegerät 52 weiter, welches die Meldung optisch ausgibt.

Falls die vorgegebene Bedingung nicht mehr erfüllt ist bzw. eines der drei zuvor genannten elektrische Signale ab- bzw. ausfällt, wird Isolationsfehler-Lokalisierungseinheit 16 mithilfe des Schalters 30 elektrisch vom Stromübertragungsnetz 10 getrennt und die Isolationsfehler-Erkennungseinheit 14 wird mit dem Stromübertragungsnetz 10 elektrisch verbunden.

Die nachfolgende Beschreibung beschränkt sich im Wesentlichen auf die Unterschiede zum vorhergehenden Ausführungsbeispiel, auf das bezüglich gleich bleibender Merkmale und Funktionen verwiesen wird. Im Wesentlichen gleiche bzw. einander entsprechende Elemente sind grundsätzlich mit den gleichen Bezugszeichen bezeichnet und nicht erwähnte Merkmale sind im folgenden Ausführungsbeispiel übernommen, ohne dass sie erneut beschrieben sind.

FIG 2 zeigt schematisch ein weiteres Fahrzeug 2. Auch in diesem Fall handelt es sich bei dem Fahrzeug 2 um ein Schienenfahrzeug.

Das Fahrzeug 2 weist ein Stromübertragungssystem 8 auf, welches ein Stromübertragungsnetz 10, ein Verbindungsleitungssystem 12, eine Isolationsfehler-Erkennungseinheit 14 und eine Isolationsfehler-Lokalisierungseinheit 16 umfasst.

Das Verbindungsleitungssystem 12 umfasst einen Schalter 30, der im vorliegend Ausführungsbeispiel als manuell betätigbarer Schalter, insbesondere als Drehschalter, ausgestaltet ist. Außerdem ist der Schalter 30 ein Wechselschalter, der dazu vorbereitet ist, die Isolationsfehler-Erkennungseinheit 14 elektrisch von Stromübertragungsnetz 10 zu trennen und dabei die Isolationsfehler-Lokalisierungseinheit 16 mit dem Stromübertragungsnetz 10 elektrisch zu verbinden. Zudem ist der Schalter 30 dazu vorbereitet, die Isolationsfehler-Lokalisierungseinheit 16 elektrisch von Stromübertragungsnetz 10 zu trennen und dabei die Isolationsfehler-Erkennungsein-heit 14 mit dem Stromübertragungsnetz 10 elektrisch zu verbinden.

Das Stromübertragungssystem 8 weist außerdem eine Prüfvorrichtung 50 auf, die zum Ermitteln einer Schaltstellung des Schalters 30 eingerichtet ist. Darüber hinaus ist das Fahrzeug 2 mit einem Ausgabegerät 52 zur Ausgabe der mittels der Prüfvorrichtung 50 ermittelten Schaltstellung sowie mit einem Zugsteuergerät 54 ausgestattet.

Des Weiteren umfasst das Stromübertragungssystem 8 eine elektrisch steuerbare Sperrvorrichtung 56, die über eine Datenleitung mit dem Zugsteuergerät 54 verbunden ist. Die Sperrvorrichtung 56 ist dazu vorbereitet, den Schalter 30 mechanisch zu sperren und wieder zu entsperren. Das Fahrzeug 2 aus FIG 1 könnte prinzipiell auch solch eine Sperrvorrichtung 56 als zusätzliche Sicherungsmaßnahme aufweisen.

Im vorliegenden Ausführungsbeispiel sind die Auswertevorrichtung 40 der Isolationsfehler-Lokalisierungseinheit 16, die Isolationsfehler-Erkennungseinheit 14 sowie das Verbindungsleitungssystem 12 im selben Wagen 4 angeordnet wie das Zugsteuergerät 54.

Während einer Fahrt des Fahrzeugs 2 ist - wie FIG 2 dargestellt - die Isolationsfehler-Erkennungseinheit 14 mittels des Schalters 30 mit dem Stromübertragungsnetz 10 elektrisch verbunden und die Isolationsfehler-Lokalisierungseinheit 16 ist mittels des Schalters 30 elektrisch vom Stromübertragungsnetz 10 getrennt. Zudem ist der Schalter 30 mithilfe der Sperrvorrichtung 56 gesperrt.

Zum Lokalisieren des Isolationsfehlers mithilfe der Isolationsfehler-Lokalisierungseinheit 16 wird das Fahrzeug 2 abgestellt.

Falls eine vorgegebene Bedingung erfüllt ist, übermittelt eine Person eines technischen Personals mittels des Zugsteuergeräts 56 ein elektrisches Entsperrsignal an die Sperrvorrichtung 56, um den Schalter 30 zu entsperren. Daraufhin entsperrt die Sperrvorrichtung 56 den Schalter 30.

Die vorgegebene Bedingung umfasst, dass das Fahrzeug 2 aufgerüstet abgestellt ist, eine Feststellbremse des Fahrzeugs 2 angezogen bzw. angelegt ist und im Zugsteuergerät 54 ein Wartungsmodus aktiviert ist.

Weiter wird die zuvor mittels des Schalters 30 elektrisch vom Stromübertragungsnetz 10 getrennte Isolationsfehler-Lokalisierungseinheit 16 mithilfe des Schalters 30 mit dem Stromübertragungsnetz 10 elektrisch verbunden, wobei der Schalter 30 von besagter Person manuell betätigt wird. Dabei wird die zuvor mittels des Schalters 30 mit dem Stromübertragungsnetz 10 elektrisch verbundene Isolationsfehler-Erkennungseinheit 14 mithilfe des Schalters 30 vom Stromübertragungsnetz 10 elektrisch getrennt.

Falls die vorgegebene Bedingung nicht mehr erfüllt ist, wird Isolationsfehler-Lokalisierungseinheit 16 mithilfe des Schalters 30 elektrisch vom Stromübertragungsnetz 10 getrennt und die Isolationsfehler-Erkennungseinheit 14 wird mit dem Stromübertragungsnetz 10 elektrisch verbunden. Hierzu wird der Schalter von der Person entsprechend betätigt. Ferner übermittelt die Person mittels des Zugsteuergeräts 54 ein elektrisches Sperrsignal an die Sperrvorrichtung 56, falls die vorgegebene Bedingung nicht mehr erfüllt ist. Daraufhin sperrt die Sperrvorrichtung 56 den Schalter 30.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können hieraus abgeleitet werden, ohne den Schutzumfang der Erfindung zu verlassen.

## Patentansprüche

1. Stromübertragungssystem (8), aufweisend zumindest ein Stromübertragungsnetz (10), eine Isolationsfehler-Erkennungseinheit (14) sowie eine Isolationsfehler-Lokalisierungseinheit (16), **gekennzeichnet durch** ein Verbindungsleitungssystem (12), welches mit dem Stromübertragungsnetz (10) sowie mittels eines als Wechselschalter ausgestalteten Schalters (30) wahlweise mit der Isolationsfehler-Erkennungseinheit (14) oder der Isolationsfehler-Lokalisierungseinheit (16) elektrisch verbunden ist, wobei der Schalter (30) dazu vorbereitet ist, die elektrische Verbindung der Isolationsfehler-Erkennungseinheit (14) mit dem Stromübertragungsnetz (10) zu trennen und die Isolationsfehler-Lokalisierungseinheit (16) elektrisch mit dem Stromübertragungsnetz (10) zu verbinden.

2. Stromübertragungssystem (8) nach Anspruch 1,
**dadurch gekennzeichnet, dass** der Schalter (30) als manuell betätigbarer Schalter, insbesondere als Drehschalter, oder als Relais ausgestaltet ist.

3. Stromübertragungssystem (8) nach Anspruch 1 oder 2, **gekennzeichnet durch** eine elektrisch steuerbare Sperrvorrichtung (56), die dazu vorbereitet ist, den Schalter (30) zu sperren und wieder zu entsperren, und/oder eine Prüfvorrichtung (50) zum Ermitteln einer Schaltstellung des Schalters (30) .

4. Stromübertragungssystem (8) nach einem der vorhergehenden Ansprüche,
**dadurch gekennzeichnet, dass** das Stromübertragungsnetz (10) mehrere Abzweigungsleitungen (18) umfasst und die Isolationsfehler-Lokalisierungseinheit (16) eine Auswertevorrichtung (40) sowie für jede der Abzweigungsleitungen (18) jeweils ein Messgerät (42), insbesondere ein Strommessgerät, und einen elektrisch mit dem Messgerät (42) verbundenen Messwandler (44), insbesondere einen Stromwandler, aufweist, wobei jeder der Messwandler (44) jeweils an einer der Abzweigungsleitungen (18) angeordnet ist und mehrere der Messgeräte (42) über einen Datenbus (48) mit der Auswertevorrichtung (40) verbunden sind.

5. Fahrzeug (2), insbesondere Schienenfahrzeug, mit einem Stromübertragungssystem (8) nach einem der vorhergehenden Ansprüche.

6. Verfahren zum Betreiben eines Stromübertragungssystems (8), bei dem ein Verbindungsleitungssystem (12) elektrisch mit einem Stromübertragungsnetz (10) sowie wahlweise mit einer Isolationsfehler-Erkennungseinheit (14) oder einer Isolationsfehler-Lokalisierungseinheit (16) verbunden ist, wobei bei Erfüllen einer vorgegebenen Bedingung die elektrische Verbindung der Isolationsfehler-Erkennungseinheit (14) mit dem Stromübertragungsnetz (10) mittels eines als Wechselschalter ausgestalteten Schalters (30) getrennt wird und die Isolationsfehler-Lokalisierungseinheit (16) mittels des Schalters (30) elektrisch mit dem Stromübertragungsnetz (10) verbunden wird.

7. Verfahren nach Anspruch 6,
**dadurch gekennzeichnet, dass** die vorgegebene Bedingung umfasst, dass sich eine Einrichtung, deren Bestandteil das Stromübertragungssystem (8) ist, in einem vorgegebenen Zustand befindet.

8. Verfahren nach einem der Ansprüche 6 oder 7,
**dadurch gekennzeichnet, dass** eine Schaltstellung des Schalters (30) ermittelt wird und die Schaltstellung optisch und/oder akustisch ausgegeben wird.

9. Verfahren nach einem der Ansprüche 6 bis 8,
**dadurch gekennzeichnet, dass** an eine elektrisch steuerbare Sperrvorrichtung (56), die dazu eingerichtet ist, den Schalter (30) zu sperren und wieder zu entsperren, ein elektrisches Entsperrsignal übermittelt wird, falls die vorgegebene Bedingung erfüllt ist, und die Sperrvorrichtung (56) den Schalter (30) daraufhin entsperrt.

10. Verfahren nach einem der Ansprüche 6 bis 9,
**dadurch gekennzeichnet, dass** der Schalter (30) ein manuell betätigbarer Schalter (30) ist und, falls die vorgegebene Bedingung erfüllt ist, eine Person den Schalter (30) manuell betätigt, oder dass der Schalter (30) ein Relais ist und, falls die vorgegebene Bedingung erfüllt ist, zum Betätigen des Schalters (30) zumindest ein vorgegebenes elektrisches Signal an den Schalter (30) übermittelt wird.

11. Verfahren nach einem der Ansprüche 6 bis 10,
**dadurch gekennzeichnet, dass** das Stromübertragungssystem (8) ein Bestandteil eines Fahrzeugs (2), insbesondere eines Schienenfahrzeugs, ist.

## Claims

1. Power transmission system (8) having at least one power transmission network (10), an insulation fault detection unit (14) and also an insulation fault locating unit (16),
**characterised by** a connecting line system (12) which is electrically connected to the power transmission network (10) and also, by means of a switch (30) embodied as a changeover switch, optionally to the insulation fault detection unit (14) or the insulation fault locating unit (16), wherein the switch (30) is designed to break the electrical connection between the insulation fault detection unit (14) and the power transmission network (10) and to electrically connect the insulation fault locating unit (16) to the power transmission network (10).

2. Power transmission system (8) according to claim 1,
**characterised in that** the switch (30) is implemented as a manually operated switch, in particular as a rotary switch, or as a relay.

3. Power transmission system (8) according to claim 1 or 2,
**characterised by** an electrically controllable locking device (56) which is designed to lock the switch (30) and unlock it again, and/or a test device (50) for determining a position of the switch (30).

4. Power transmission system (8) according to one of the preceding claims,
**characterised in that** the power transmission network (10) comprises a plurality of branch circuits (18) and the insulation fault locating unit (16) has an evaluation device (40) and, for each of the branch circuits (18), a measuring instrument (42), in particular an ammeter, and an instrument transformer (44), in particular a current transformer electrically connected to the measuring instrument (42), wherein each of the instrument transformers (44) is disposed on one of the branch circuits (18) and a plurality of the measuring instruments (42) are connected to the evaluation device (40) via a data bus (48).

5. Vehicle (2), in particular a rail vehicle, having a power transmission system (8) according to one of the preceding claims.

6. Method for operating a power transmission system (8), wherein a connecting line system (12) is electrically connected to a power transmission network (10) and also optionally to an insulation fault detection unit (14) or an insulation fault locating unit (16), wherein, if a predefined condition is fulfilled, the electrical connection between the insulation fault detection unit (14) and the power transmission network (10) is broken by means of a switch (30) embodied as a changeover switch and the insulation fault locating unit (16) is electrically connected to the power transmission network (10) by means of the switch (30).

7. Method according to claim 6,
**characterised in that** the predefined condition includes a device of which the power transmission system (8) is a constituent part in a predefined state.

8. Method according to one of claims 6 or 7,
**characterised in that** a position of the switch (30) is determined and the switch position is visually and/or audibly output.

9. Method according to one of claims 6 to 8,
**characterised in that**, if the predefined condition is fulfilled, an electrical unlocking signal is transmitted to an electrically controllable locking device (56) which is designed to lock the switch (30) and unlock it again, whereupon the locking device (56) unlocks the switch (30).

10. Method according to one of claims 6 to 9,
**characterised in that** the switch (30) is a manually operated switch (30) and if the predefined condition is fulfilled, a person manually operates the switch (30), or that the switch (30) is a relay and if the predefined condition is fulfilled, at least one predefined electrical signal is transmitted to the switch (30) to actuate the switch (30).

11. Method according to one of claims 6 to 10, **characterised in that** the power transmission system (8) is a constituent part of a vehicle (2), in particular of a rail vehicle.

## Revendications

1. Système (8) de transport de courant, comportant au moins un réseau (10) de transport de courant, une unité (14) de détection d'un défaut d'isolation, ainsi qu'une unité (16) de localisation d'un défaut d'isolation, **caractérisé par** un système (12) de ligne de liaison, qui est relié électriquement au réseau (10) de transport de courant, ainsi que, au moyen d'un commutateur (30) en va-et-vient, au choix, à l'unité (14) de détection d'un défaut d'isolation ou à l'unité (16) de localisation d'un défaut d'isolation, le commutateur étant préparé pour coupler la liaison électrique de l'unité (14) de détection d'un défaut d'isolation au réseau (10) de transport de courant et relier électriquement l'unité (16) de localisation d'un défaut d'isolation au réseau (10) de transport de courant.

2. Système (8) de transport de courant suivant la revendication 1,
**caractérisé en ce que** le commutateur (30) est conformé en commutateur pouvant être actionné manuellement, notamment en commutateur tournant ou sous la forme d'un relais.

3. Système (8) de transport de courant suivant la revendication 1 ou 2,
**caractérisé par** un dispositif (56) de blocage, qui peut être commandé électriquement et qui est préparé pour bloquer le commutateur (30) et le redébloquer et/ou un dispositif (50) de contrôle pour déterminer une position de commutation du commutateur (30).

4. Système (8) de transport de courant suivant l'une des revendications précédentes,
**caractérisé en ce que** le réseau (10) de transport de courant comprend plusieurs lignes (18) de dérivation et l'unité (16) de localisation d'un défaut d'isolation a un dispositif (40) d'exploitation, ainsi que, pour chacune des lignes (18) de dérivation, respectivement un appareil (42) de mesure, notamment un appareil de mesure du courant, et un transducteur (44) de mesure, relié électriquement à l'appareil (42) de mesure, notamment un transducteur de courant, chacun des transducteurs (44) de mesure étant monté respectivement sur l'une des lignes (18) de dérivation et plusieurs des appareils (42) de mesure étant reliés au dispositif (40) d'exploitation par un bus (48) de données.

5. Véhicule (2), notamment véhicule ferroviaire ayant un système (8) de transport de courant suivant l'une des revendications précédentes.

6. Procédé pour faire fonctionner un système (8) de transport de courant, dans lequel un système (12) de ligne de liaison est relié électriquement à un réseau (10) de transport de courant, ainsi que, au choix, à une unité (14) de détection d'un défaut d'isolation ou à une unité (16) de localisation d'un défaut d'isolation, dans lequel, lorsqu'une condition donnée à l'avance est satisfaite, la liaison électrique de l'unité (14) de détection d'un défaut d'isolation au réseau (10) de transport de courant est coupée au moyen d'un commutateur (30) conformé en commutateur en va-et-vient et l'unité (16) de localisation d'un défaut d'isolation est reliée électriquement au réseau (10) de transport de courant au moyen du commutateur (30).

7. Procédé suivant la revendication 6,
**caractérisé en ce que** la condition donnée à l'avance comprend le fait qu'un dispositif, dont le constituant est le système (8) de transport de courant, se trouve dans un état donné à l'avance.

8. Procédé suivant l'une des revendications 6 ou 7,
**caractérisé en ce que** l'on détermine une position de commutation du commutateur (30) et l'on émet optiquement et/ou acoustiquement la position de commutation.

9. Procédé suivant l'une des revendications 6 à 8,
**caractérisé en ce que** l'on transmet un signal électrique de déblocage à un dispositif (56) de blocage, qui peut être commandé électriquement et qui est conçu pour bloquer et redébloquer le commutateur (30), si la condition donnée à l'avance est satisfaite, et le dispositif (56) de blocage débloque ensuite le commutateur (30).

10. Procédé suivant l'une des revendications 6 à 9,
**caractérisé en ce que** le commutateur (30) est un commutateur (30) pouvant être actionné manuellement et, si la condition donnée à l'avance est satisfaite, une personne actionne manuellement le commutateur (30) ou **en ce que** le commutateur (30) est un relais et, si la condition donnée à l'avance est satisfaite, il est transmis au commutateur (30) en vue d'actionner le commutateur (30) au moins un signal électrique donné à l'avance.

11. Procédé suivant l'une des revendications 6 à 10,
**caractérisé en ce que** le système (8) de transport de courant fait partie d'un véhicule (2), notamment d'un véhicule ferroviaire.
